# FASCICULE DE BREVET EUROPEEN

(11) **EP 3 338 311 B1**
(45) Date de publication et mention de la délivrance du brevet: **13.03.2019**
(21) Numéro de dépôt: 16770041.8
(22) Date de dépôt: 18.08.2016
(51) Int. Cl.: H01L 35/08, H01L 35/18

(54) **ÉLÉMENT THERMOÉLECTRIQUE AMÉLIORÉ ET CONVERTISSEUR THERMOÉLECTRIQUE COMPORTANT AU MOINS UN TEL ÉLÉMENT**
VERBESSERTES THERMOELEMENT UND THERMOELEKTRISCHER WANDLER MIT MINDESTENS EINEM SOLCHEN ELEMENT
IMPROVED THERMOELECTRIC ELEMENT AND THERMOELECTRIC CONVERTER INCLUDING AT LEAST ONE SUCH ELEMENT

(30) Priorité: 21.08.2015 FR 1557857
(43) Date de publication de la demande: 27.06.2018
(73) Titulaire: Université de Lorraine, 54000 Nancy (FR); Centre National de la Recherche Scientifique, 75016 Paris 16 (FR)
(72) Inventeur: GECZI, Eugen, 79114 Freiburg (DE); JACQUOT, Alexandre, 79540 Lörrach (DE); KENFAUI, Driss, 31000 Toulouse (FR); KOGUT, Iurii, Lviv 79060 (UA); LENOIR, Bertrand, 88700 Jeanmenil (FR); MASSCHELEIN, Philippe, 54740 Vaudigny (FR)
(74) Mandataire: Merckling, Norbert
(86) Numéro de dépôt international: PCT/FR2016/052091
(87) Numéro de publication internationale: WO 2017/032943

(56) Documents cités:
- JP-A- H06 310 765
- JP-A- 2009 260 173
- US-A1- 2006 017 170
- US-A1- 2012 006 376
- US-A1- 2014 216 515
- US-B2- 7 402 910

## Description

### Domaine technique

La présente invention se rapporte au domaine technique général des convertisseurs thermoélectriques et des éléments thermoélectriques utilisés pour réaliser de tels convertisseurs. Les convertisseurs ou dispositifs thermoélectriques permettent de produire du « froid » (applications en réfrigération/climatisation) mais aussi de valoriser les effluents thermiques pour produire, de manière élégante, de l'électricité. Dans ce dernier domaine, ils sont envisagés pour être utilisés par exemple dans l'industrie automobile pour la conversion de la chaleur au niveau des gaz d'échappement.

D'autres domaines d'application tels que la micro-cogénération à partir notamment de la biomasse, l'alimentation électrique d'objets connectés à Internet, l'alimentation de réseaux de capteurs, l'alimentation des systèmes dans des zones reculées et hostiles à l'homme ainsi que l'alimentation électrique dans le domaine spatial, sont par exemple des domaines d'application des éléments et convertisseurs thermoélectriques tels que présentés ci-après.

L'invention concerne plus particulièrement la conception et la fabrication d'éléments thermoélectriques, comprenant une couche thermoélectrique sous forme massive et d'épaisseur très réduite, lesquels entrent dans la fabrication de convertisseurs thermoélectriques. Par couche thermoélectrique sous forme massive et d'épaisseur réduite il convient d'entendre que la couche est fabriquée par l'intermédiaire de procédés empruntés à la métallurgie des poudres et non à partir de techniques de dépôts sous vide (communément appelé couches minces) par voie physique ou chimique.

### Etat de la technique

Il est connu qu'une réduction des dimensions des éléments thermoélectriques, appelés également jambes thermoélectriques, permet d'obtenir une densité de puissance électrique accrue. On pourra se reporter aux documents US 6,388,185 B1 et US 5,712,448 A1. De même, il est connu qu'une augmentation de température aux bornes des jambes thermoélectriques permet d'accroître la densité de puissance électrique. Cependant, compte tenu des contraintes thermomécaniques importantes liées à des coefficients de dilatation thermique différenciés entre ses différents éléments constitutifs, il a été trop souvent considéré comme très difficile voire impossible de diminuer les dimensions de tels éléments thermoélectriques tout en assurant un fonctionnement fiable sous un écart de température appréciable.

En effet, les matériaux thermoélectriques sous forme massive présentent généralement un comportement mécanique fragile et les contraintes thermomécaniques provoquent un endommagement irréversible (fissures) en particulier au voisinage de l'interface avec les électrodes métalliques ou au centre du matériau thermoélectrique lorsque ce dernier est de bonne qualité. Ceci a pour effet de dégrader significativement les performances du convertisseur thermoélectrique.

A cette complexité s'ajoute celle liée aux problèmes de diffusion chimique entre les jambes thermoélectriques et les électrodes, problèmes qui s'intensifient avec l'augmentation de température. Le phénomène de diffusion mène à une dégradation progressive des propriétés thermoélectriques et mécaniques qui, in fine, conduit à un dysfonctionnement du dispositif.

Le générateur thermoélectrique le plus aboutit intégrant des jambes de faible épaisseur était celui développé par la société MICROPELT. On pourra par exemple se reporter au document US 7,402,910 B2. Cependant, le matériau thermoélectrique utilisé, à base de Bi₂Te₃, et la méthode de fabrication des éléments thermoélectriques par dépôts physiques (couches minces), fixent des limites pratiques sévères sur la plage de température d'utilisation (autour de la température ambiante) et sur les dimensions des convertisseurs (quelques dizaines de micromètre d'épaisseur). Cette technologie à base de couches minces reste donc cantonnée à des applications où les besoins en puissances électriques n'excèdent pas la dizaine de milliwatts.

Pour s'affranchir des problèmes techniques explicités auparavant, les générateurs thermoélectriques actuels sont constitués d'éléments N et P dont la longueur est de l'ordre du centimètre. Ces éléments sont brasés avec une fine couche de brasure à des électrodes métalliques.

JP H06 310765 A divulgue un élément thermoélectrique comportant un assemblage de couches constitutives comprenant une couche centrale en matériau thermoélectrique de type N ou P, puis selon une direction d'assemblage et de chaque côté de ladite couche centrale, une couche intermédiaire formant une barrière de diffusion suivie d'une couche tampon en matériau métallique (cuivre), lesdites couches tampons étant destinées à être solidarisées à des électrodes métalliques.

### Description de l'invention

L'objet de la présente invention vise par conséquent à pallier les inconvénients de l'art antérieur en fournissant un nouvel élément ou convertisseur thermoélectrique comprenant une couche thermoélectrique sous forme massive et d'épaisseur très réduite, lequel entre dans la fabrication de convertisseurs thermoélectriques présentant des performances considérablement améliorées.

Un autre objet de la présente invention vise à proposer un nouvel élément ou convertisseur thermoélectrique obtenu en employant un procédé de fabrication efficace et économique.

Un autre objet de la présente invention vise à proposer un nouvel élément ou convertisseur thermoélectrique dont la fiabilité dans le temps est améliorée et ce dans une plage de température relativement élevée, comprise par exemple entre 300°K et 900°K.

Les objets assignés à l'invention sont atteints à l'aide d'un élément thermoélectrique notamment pour convertisseur thermoélectrique comportant un assemblage de couches constitutives comprenant une couche centrale en matériau thermoélectrique de type N ou P, puis selon une direction d'assemblage et de chaque côté de ladite couche centrale, une couche intermédiaire formant une barrière de diffusion suivie d'une couche tampon en matériau métallique composite, lesdites couches tampons étant destinées à être solidarisées à des électrodes métalliques, caractérisé en ce que l'épaisseur cumulée des deux couches tampons est supérieure ou égale à 50% de l'épaisseur de la couche centrale, et préférentiellement supérieure ou égale à 100% de l'épaisseur de la couche centrale et très préférentiellement supérieure ou égale à 200% de l'épaisseur de la couche centrale et en ce que le matériau constitutif des couches tampons est un alliage de deux métaux choisis parmi la famille : TixAg1-x, VxFe1-x, VxAg1-x, TixFe1-x, avec 0 < x < 1.

La couche centrale, dite également couche active, est de préférence réalisée sous forme massive et présente une épaisseur réduite.

Selon un exemple de réalisation de l'élément thermoélectrique conforme à l'invention, la couche centrale présente une épaisseur comprise entre 200 µm et 2000 µm.

Selon un exemple de réalisation de l'élément thermoélectrique conforme à l'invention, l'épaisseur de chaque couche tampon est comprise entre 500 µm et 5000 µm.

Selon un exemple de réalisation de l'élément thermoélectrique conforme à l'invention, chaque couche intermédiaire présente une épaisseur comprise entre 10 µm et 200 µm.

Selon un exemple de réalisation conforme à l'invention, l'élément thermoélectrique, présente selon une section transversale à la direction d'assemblage, une surface comprise entre 4 mm² et 100 mm².

Selon un exemple de réalisation de l'élément thermoélectrique conforme à l'invention, le matériau constitutif de la couche centrale est de la skuttérudite par exemple à base de CoSb₃, de type N ou P.

Selon un exemple de réalisation de l'élément thermoélectrique conforme à l'invention, le matériau constitutif des couches tampons est un alliage de deux métaux choisis parmi la famille : TiₓAg₁₋ₓ, VₓFe₁₋ₓ, VₓAg₁₋ₓ, TiₓFe₁₋ₓ, avec x étant une fraction atomique comprise strictement entre 0 et 1, c'est-à-dire avec 0 < x < 1 (x strictement supérieur à 0 et x strictement inférieur à 1).

A titre d'exemple, un matériau thermoélectrique ayant un coefficient de dilatation thermique de 10⁻⁵ K⁻¹ se combinera bien par exemple avec un composite TiₓAg₁₋ₓ où x = 0,86 tandis qu'un matériau thermoélectrique ayant un coefficient de dilatation thermique de 13x10⁻⁶ K⁻¹ se combinera mieux avec un matériau ayant une composition où x = 0,57. Ces chiffres restent valables à +/- 30% pour des composites de type VₓFe₁₋ₓ, VₓAg₁₋ₓ et TiₓFe₁₋ₓ.

Selon un exemple de réalisation de l'élément thermoélectrique conforme à l'invention, le matériau constitutif des couches intermédiaires est choisi parmi la famille de matériaux comprenant le nickel, titane, chrome, tantale, hafnium, niobium, zirconium, vanadium, tungstène, yttrium, nitrure de tantale, oxyde d'indium, siliciure de cuivre, nitrure de tungstène, nitrure de titane.

Les objets assignés à l'inventions sont également atteints à l'aide d'un convertisseur thermoélectrique comportant deux plaques en matériau céramique parallèles entre elles et espacées l'une de l'autre par l'intermédiaire d'un ensemble d'éléments thermoélectriques tels que précités, des électrodes métalliques étant solidarisées d'une part avec des faces en vis-à-vis desdites plaques selon une répartition déterminée, et d'autre part avec les couches tampons par l'intermédiaire d'une couche de brasure.

Selon un exemple de réalisation conforme à l'invention, la couche de brasure s'étendant entre les couches tampons et les électrodes, contient notamment de l'aluminium.

Selon un autre exemple de réalisation conforme à l'invention l'épaisseur de la couche de brasure est égale ou inférieure à l'épaisseur des couches tampons en matériau métallique composite. L'épaisseur de la couche de brasure est par exemple comprise entre 50% et 200 % de l'épaisseur des électrodes imprimées sur les plaques en matériau céramique.

Avantageusement, cette brasure ou couche de brasure se répartit également sur toutes les surfaces libres et sur toute la longueur des électrodes imprimées sur les plaques en matériau céramique afin d'en diminuer la résistance électrique. La brasure couvre également les couches tampon au moins en partie. Les couches tampons sont mises à profit pour augmenter, par exemple de 50% à 200%, l'épaisseur des électrodes métalliques connectant les couches thermoélectriques centrales, par ajout de matériau de brasure sur les surfaces libres de celles-ci.

Selon un exemple de réalisation du convertisseur thermoélectrique conforme à l'invention, la couche de brasure recouvre la totalité de la face libre de l'électrode métallique, ladite face libre étant la face opposée de la face de l'électrode liée à la plaque en matériau céramique.

Selon un exemple de réalisation du convertisseur thermoélectrique conforme à l'invention, la couche de brasure s'étend également autour de la couche tampon en formant une collerette périphérique enveloppant ladite couche tampon sur une partie de sa hauteur.

L'élément thermoélectrique conforme à l'invention présente l'énorme avantage de permettre un assemblage aisé entre les couches tampon et des électrodes en cuivre, éventuellement nickelé, en utilisant une brasure contenant de l'aluminium.

Cette brasure peut être utilisée en couche épaisse et mouiller avantageusement la couche tampon. La tension superficielle permet de réaliser un assemblage résistant des deux matériaux. On obtient ainsi une excellente cohésion mécanique ainsi qu'une conduction électrique optimale permettant d'utiliser des courants plus importants. Les résistances de contacts entre l'électrode et la couche tampon sont négligeables par rapport à la résistance intrinsèque des éléments thermoélectriques. Elles sont en effet trop faibles pour être mesurables.

Un autre avantage de l'élément thermoélectrique conforme à l'invention et plus particulièrement lié à son procédé de fabrication particulièrement facile à mettre en oeuvre. En effet, deux étapes seulement sont nécessaires. La première étape consiste à fabriquer les couches tampons et la seconde étape consiste à assembler toutes les couches constitutives. Cette seconde étape est réalisée dans un bâti SPS (Spark Plasma Sintering).

Un autre avantage de l'élément thermoélectrique conforme à l'invention réside dans l'obtention d'une densité de puissance au moins triplée et ce en utilisant entre 4 et 5 fois moins de matériau thermoélectrique dans la couche centrale. On réalise ainsi une économie substantielle.

En outre, les matériaux thermoélectriques utilisés, en l'occurrence la skuttérudite à l'état massif, présentent de très bonnes performances thermoélectriques mais sont réputés pour être relativement fragiles.

L'élément thermoélectrique conforme à l'invention permet non seulement, la réduction des dimensions (épaisseur de la couche centrale du matériau thermoélectrique) mais également d'augmenter ses performances électriques. De plus, il permet de mieux résister aux contraintes thermomécaniques dues aux différences entre coefficients d'expansion thermique des différents matériaux.

La fabrication en une seule étape par pressage à chaud (basé sur la technique SPS) de l'élément thermoélectrique (jambe thermoélectrique) consistant notamment à connecter les couches tampon supérieure et inférieure et à l'isoler par une couche intermédiaire constituant une barrière de diffusion est substantiellement simplifiée par rapport à la solution qui consisterait à déposer la barrière de diffusion par dépôt physique (couche mince). Cette solution (couche mince) est particulièrement inadaptée pour les épaisseurs des barrières de diffusion considérées, à savoir de plusieurs microns à plusieurs dizaines de microns.

La simplification de ce procédé réside en l'établissement des liaisons des deux côtés du matériau thermoélectrique, sous des conditions optimisées du pressage à chaud, avec la barrière de diffusion et la couche tampon, concomitamment avec le frittage du matériau thermoélectrique introduit préalablement sous forme de poudre.

L'épaisseur de la couche tampon est mise à profit lors du brasage avec les électrodes métalliques, par exemple en cuivre, puisqu'elle évite que la brasure ne déborde sur l'élément thermoélectrique. En revanche, la brasure déborde sur les électrodes métalliques et sur les couches tampons, ce qui permet de réduire les résistances électriques et in fine de favoriser le passage de courant plus intense.

La réduction des contraintes, en-dessous de la contrainte à la rupture de la skutterudite, est essentiellement liée aux matériaux composites des couches tampons qui leur confèrent un coefficient de dilatation thermique similaire à celui du matériau thermoélectrique mais également à l'épaisseur relativement importante desdites couches tampons, permettant ainsi d'absorber les contraintes mécaniques et de ne pas les concentrer dans le matériau thermoélectrique.

Par ailleurs, ce procédé permet l'obtention de très faibles résistances de contact. Par exemple, les résistances de contact mesurées aux interfaces skutterudites / barrière de diffusion - couches TiₓAg₍₁₋ₓ₎ ont affiché des valeurs aussi basses que 2 µΩ cm² (élément de type P) et 7 µΩ cm² (élément de type N). Elles sont de 3 à 10 fois plus faibles que les meilleurs valeurs rapportées jusqu'à aujourd'hui. On pourra se reporter au document Fleurial et al. (US 2012/0006376 A1).

Un autre avantage de l'invention réside dans la possibilité d'utiliser la technologie de brasage par laser pour solidariser les couches tampons aux électrodes métalliques ou tous procédés du type additif pour construire le convertisseur thermoélectrique y compris les échangeurs thermiques. Les matériaux sont ainsi moins soumis à des chocs thermiques.

Un autre avantage de l'élément thermoélectrique conforme à l'invention réside dans la diminution de leur encombrement. De plus, la surface du matériau thermoélectrique exposée à l'atmosphère est également réduite, ce qui augmente sa stabilité en température. Les couches tampons constituent également de bon point d'ancrage pour une barrière physique, par exemple une encapsulation, évitant la décomposition (sublimation) du matériau thermoélectrique opérée à haute température. On pourra se reporter par exemple au document US 7,480,984 B1.

### Brève description des dessins

D'autres caractéristiques et avantages de la présente invention apparaîtront plus clairement à la lecture de la description qui va suivre, faite en référence aux dessins annexés, donnés à titre d'exemples non limitatifs, dans lesquels :
- la figure 1 est une vue en perspective d'un exemple de réalisation d'un élément thermoélectrique conforme à l'invention et lié à des électrodes,
- la figure 2 est une représentation partielle d'un autre exemple de réalisation d'un élément thermoélectrique conforme à l'invention, et
- la figure 3 est une vue en perspective, partiellement découpée, d'un exemple de réalisation d'un convertisseur thermoélectrique conforme à l'invention.

### Mode(s) de réalisation de l'invention

Les éléments structurellement et fonctionnellement identiques et présents sur plusieurs figures distinctes, sont affectés d'une même référence numérique ou alphanumérique.

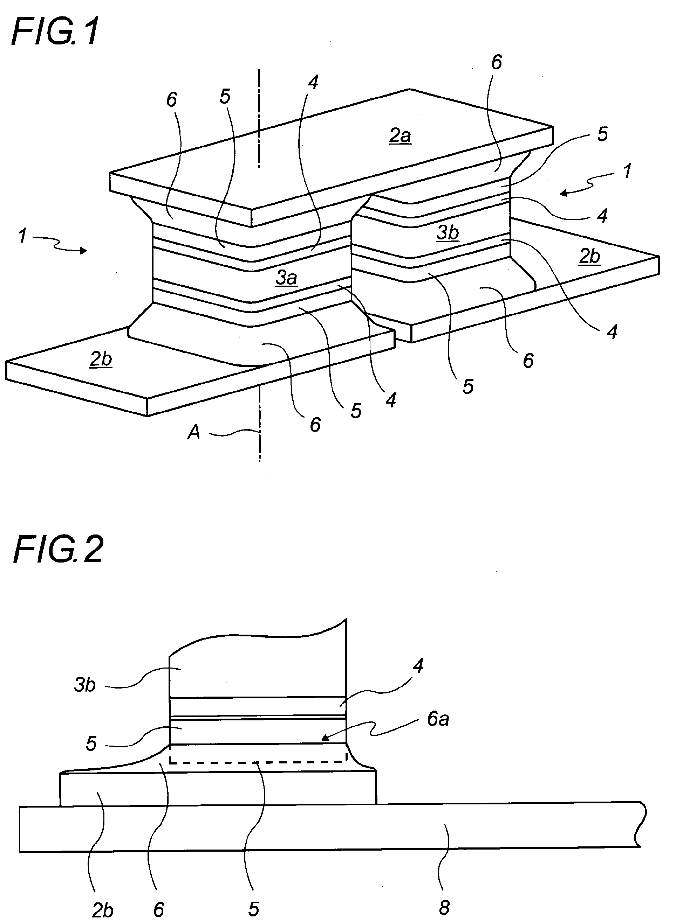

La figure 1 est une vue en perspective d'un exemple de réalisation d'un élément thermoélectrique (1) conforme à l'invention. La figure 1 présente plus précisément un assemblage de deux éléments thermoélectriques (1) conformes à l'invention et assemblés à l'aide d'une électrode supérieure (2a). Chacun des éléments thermoélectriques (1) est également liés à une électrode inférieure (2b) respective. Les électrodes (2a) et (2b) sont de nature métallique.

L'élément thermoélectrique (1) conforme à l'invention comporte un assemblage de couches constitutives comprenant notamment une couche centrale (3a) ou (3b). La couche centrale (3a) est par exemple réalisée en matériau thermoélectrique de type N et la couche centrale (3b) est par exemple réalisée en matériau thermoélectrique de type P. Les couches centrales (3a) et (3b) sont ainsi préférentiellement réalisées respectivement en skuttérudite de type N et P.

L'élément thermoélectrique (1) comprend également selon une direction d'assemblage longitudinale A et de chaque côté de la couche centrale (3a) et (3b) une couche intermédiaire (4) formant une barrière de diffusion.

La barrière de diffusion a pour rôle d'empêcher la diffusion des éléments chimiques du matériau thermoélectrique vers des couches tampons (5) et vis-versa, ce qui permet de préserver les propriétés électriques, thermiques et mécaniques de celui-ci lors du fonctionnement du convertisseur thermoélectrique.

Le matériau constitutif des couches intermédiaires (4) est choisi parmi la famille de matériaux comprenant le nickel, le titane, le chrome, le tantale, le hafnium, le niobium, le zirconium, le vanadium, l'yttrium, le tungstène, le nitrure de tantale, l'oxyde d'indium, le siliciure de cuivre, le nitrure de tungstène et le nitrure de titane.

Les matériaux constitutifs des couches intermédiaires (4) sont avantageusement choisis pour s'adapter à la nature de la couche centrale (3a) ou (3b) à savoir le matériau thermoélectrique du type N ou P. Avec les skutterudites, plusieurs métaux parmi ceux cités préalablement ont conduits à des résultats très positifs.

Chaque couche intermédiaire (4) est suivie d'une couche tampon (5) en matériau métallique composite. Les couches tampon (5) sont destinées à être solidarisées avec les électrodes métalliques (2a) ou (2b). Une telle solidarisation est de préférence obtenue par l'intermédiaire d'une couche de brasure (6) contenant notamment de l'aluminium. L'épaisseur importante des couches tampon (5) permet d'utiliser une quantité de brasure plus grande par rapport à celle de l'état de la technique connu, sans risque de court-circuit.

Par ailleurs, il est avantageux que la brasure (6) déborde sur la couche tampon (5) pour améliorer ses performances électriques.

Le matériau constitutif des couches tampons (5) est de préférence un composite de deux métaux choisis parmi la famille de couples de métaux comprenant l'argent et le titane, le fer et le vanadium, l'argent et le vanadium et le fer et le titane. Les proportions des deux matériaux constitutifs de la couche tampon (5) sont précisées de la manière suivante, avec x étant une fraction atomique comprise strictement entre 0 et 1, c'est-à-dire avec 0 < x < 1. Le matériau composite constitutif des couches tampons (5) est ainsi un composite de deux métaux choisis parmi la famille : TiₓAg₁₋ₓ, VₓFe₁₋ₓ, Vₓ Ag₁₋ₓ, TiₓFe₁₋ₓ.

Chaque couche tampon (5) est liée aux électrodes métalliques à l'aide de la couche de brasure (6).

La couche de brasure (6), comme illustré sur la figure 2, reliant chaque couche tampon (5) aux électrodes (2a, 2b) se répartit également sur toutes les faces libres et sur toute la longueur des électrodes (2a, 2b) imprimées sur les plaques (8, 9) en matériau céramique, afin d'en diminuer la résistance électrique. La brasure (6) couvre également les couches tampons (5).

L'épaisseur de la couche de brasure (6) est dans ce cas typiquement égale ou inférieure à l'épaisseur des couches tampon (5) composites et comprise entre 50 et 200 % de l'épaisseur des électrodes (2a, 2b) imprimées sur les plaques (8, 9) en matériau céramique.

Le matériau de la couche de brasure (6) s'étale donc avantageusement sur la face libre de l'électrode métallique (2a, 2b) pour en recouvrir au moins une partie ou la totalité de sa surface non recouverte par la couche tampon (5).

Avantageusement, la couche de brasure (6), illustrée par exemple à la figure 2, s'étend également autour de la couche tampon (5) en formant une collerette périphérique (6a) enveloppant ladite coucha tampon (5) sur une partie de sa hauteur.

Les différentes proportions envisageables peuvent avantageusement être adaptées au matériau thermoélectrique de type N ou P de la couche centrale (3a) ou (3b). Dans le cas de TiₓAg₁₋ₓ, la valeur de x est de 0,86 pour l'élément thermoélectrique de type N et 0,57 pour celui de type P.

Avantageusement l'épaisseur cumulée des deux couches tampons (5) d'un élément thermoélectrique (1) conforme à l'invention est supérieure ou égale à 50 % de l'épaisseur de la couche centrale (3a) ou (3b).

Selon un autre exemple de réalisation préférentiel, cette épaisseur cumulée est supérieure ou égale à 100 % de l'épaisseur de la couche centrale (3a) ou (3b).

Selon encore un autre exemple particulièrement préféré, ladite épaisseur cumulée est supérieure ou égale à 200 % de l'épaisseur de ladite couche centrale (3a) ou (3b).

A titre d'exemple, la couche centrale (3a) ou (3b) présente une épaisseur comprise entre 200 µm et 2000 µm.

L'épaisseur de chaque couche tampon (5) est comprise entre 500 µm et 5000 µm.

L'épaisseur de chaque couche intermédiaire (3) est de préférence comprise entre 10 µm et 200 µm.

Un élément thermoélectrique (1) conforme à l'invention présente avantageusement selon une section transversale à la direction d'assemblage A, une surface comprise entre 4 mm² et 100 mm².

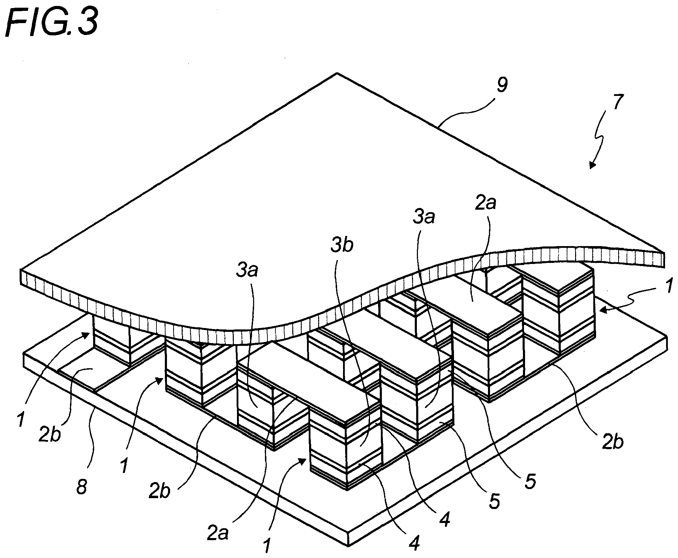

La figure 3 est une vue en perspective, partiellement découpée, d'un exemple de réalisation d'un convertisseur thermoélectrique (7) conforme à l'invention, intégrant les éléments thermoélectriques (1) conforme à l'invention. Le convertisseur thermoélectrique (7) conforme à l'invention comporte deux plaques en matériau céramique (8) et (9) sensiblement parallèle entre elles et espacées l'une de l'autre par l'intermédiaire d'un ensemble d'éléments thermoélectriques (1).

Les électrodes métalliques (2a) et (2b) sont respectivement solidarisées sur des faces en vis-à-vis desdites plaques (8) et (9) en matériau céramique.

La répartition et la fixation des électrodes (2a) et (2b) sur les plaques respectives (8) et (9) en matériau céramique est effectuée selon des technologies connues, de manière à permettre d'assembler lesdites plaques (8) et (9) avec les éléments thermoélectriques (1) conforme à l'invention.

A titre d'exemple, deux assemblages de douze éléments thermoélectriques (1), six de type N et six de type P, conformes à l'invention, ont été réalisés et leur puissance électrique a été mesurée. Chaque élément thermoélectrique comprend des couches tampons (5) en TiₓAg₁₋ₓ, une barrière de diffusion en Ni et une couche thermoélectrique, à savoir : skutterudite In_{0,4}Co₄Sb₁₂ pour le type N et skutterudite Ce_{0,9}Fe_{3,5}Co_{0,5}Sb₁₂ pour le type P. Les épaisseurs respectives de ces couches étaient de 1000 µm, 10 µm et 500 µm pour le premier assemblage et 1000 µm, 10 µm et 1000 µm pour le second. La surface transversale de chaque élément thermoélectrique était d'environ 2,5 mm x 2,5 mm, soit 6,25 mm² pour le premier et 2 mm x 2 mm, soit 4 mm² pour second.

Soumis à une différence de température de 500 °K, la puissance électrique mesurée était de 3,1 W, soit une densité de puissance de 4,1 W.cm⁻² pour le premier et 3,6 W, soit une densité de puissance de 7,5 W.cm⁻² pour le second.

Ces densités de puissance obtenues sont tout à fait remarquables comparées aux valeurs de l'état de la technique, lesquelles sont au mieux de l'ordre de 1 W.cm⁻², et compte tenu de la faible quantité de matériau thermoélectrique utilisé.

Il est évident que la présente description ne se limite pas aux exemples explicitement décrits, mais comprend également d'autres modes de réalisation et/ou de mise en oeuvre. Ainsi, une caractéristique technique décrite peut être remplacée par une caractéristique technique équivalente sans sortir du cadre de la présente invention telle que définie par les revendications.

## Revendications

1. Elément thermoélectrique (1) notamment pour convertisseur thermoélectrique (7) comportant un assemblage de couches constitutives comprenant une couche centrale (3a, 3b) en matériau thermoélectrique de type N ou P, puis selon une direction d'assemblage et de chaque côté de ladite couche centrale (3a, 3b), une couche intermédiaire (4) formant une barrière de diffusion suivie d'une couche tampon (5) en matériau métallique composite, lesdites couches tampons (5) étant destinées à être solidarisées à des électrodes métalliques (2a, 2b), l'épaisseur cumulée des deux couches tampons (5) étant supérieure ou égale à 50% de l'épaisseur de la couche centrale (3a, 3b), et préférentiellement supérieure ou égale à 100% de l'épaisseur de la couche centrale (3a, 3b) et très préférentiellement supérieure ou égale à 200% de l'épaisseur de la couche centrale (3a, 3b), **caractérisé en ce que** le matériau constitutif des couches tampons (5) est un alliage de deux métaux choisis parmi la famille : TiₓAg₁₋ₓ, VₓFe₁₋ₓ, VₓAg₁₋ₓ, TiₓFe₁₋ₓ, avec 0 < x < 1.

2. Elément thermoélectrique (1) selon la revendication 1, **caractérisé en ce que** la couche centrale (3a, 3b) présente une épaisseur comprise entre 200 µm et 2000 µm.

3. Elément thermoélectrique (1) selon la revendication 1 ou 2, **caractérisé en ce que** l'épaisseur de chaque couche tampon (5) est comprise entre 500 µm et 5000 µm.

4. Elément thermoélectrique (1) selon l'une quelconque des revendications 1 à 3, caractérisé en ce chaque couche intermédiaire (4) présente une épaisseur comprise entre 10 µm et 200 µm.

5. Elément thermoélectrique (1) selon l'une quelconque des revendications 1 à 4, **caractérisé en ce qu'**il présente, selon une section transversale à la direction d'assemblage, une surface comprise entre 4 mm² et 100 mm².

6. Elément thermoélectrique (1) selon l'une quelconque des revendications 1 à 5, **caractérisé en ce que** le matériau constitutif de la couche centrale (3a, 3b) est de la skuttérudite de type N ou P.

7. Elément thermoélectrique (1) selon l'une quelconque des revendications 1 à 6, **caractérisé en ce que** le matériau constitutif des couches intermédiaires (4) est choisi parmi la famille de matériaux comprenant le nickel, titane, chrome, tantale, hafnium, niobium, zirconium, vanadium, yttrium, tungstène, nitrure de tantale, oxyde d'indium, siliciure de cuivre, nitrure de tungstène, nitrure de titane.

8. Convertisseur thermoélectrique (7) comportant deux plaques en matériau céramique (8, 9) sensiblement parallèles entre elles et espacées l'une de l'autre par l'intermédiaire d'un ensemble d'éléments thermoélectriques (1) conformes à l'une quelconque des revendications 1 à 7 et des électrodes métalliques (2a, 2b) solidarisées avec d'une part des faces en vis-à-vis desdites plaques (8, 9) selon une répartition déterminée et d'autre part avec les couches tampons (5) par l'intermédiaire d'une couche de brasure (6).

9. Convertisseur thermoélectrique (7) selon la revendication 8, **caractérisé en ce que** la couche de brasure (6) disposée entre les couches tampons (5) et les électrodes métallique (2a, 2b) contient notamment de l'aluminium.

10. Convertisseur thermoélectrique (7) selon la revendication 8 ou 9, **caractérisé en ce que** l'épaisseur de la couche de brasure (6) est égale ou inférieure à l'épaisseur des couches tampons (5) en matériau métallique composite.

11. Convertisseur thermoélectrique (7) selon l'une quelconque des revendications 8 à 10, **caractérisé en ce que** l'épaisseur de la couche de brasure (6) est comprise entre 50% et 200 % de l'épaisseur des électrodes (2a, 2b) imprimées sur les plaques (8, 9) en matériau céramique.

12. Convertisseur thermoélectrique (7) selon l'une quelconque des revendications 8 à 11, **caractérisé en ce que** la couche de brasure (6) recouvre au moins une partie de la face libre de l'électrode métallique (2a, 2b).

13. Convertisseur thermoélectrique (7) selon l'une quelconque des revendications 8 à 12, **caractérisé en ce que** la couche de brasure (6) s'étend autour de la couche tampon (5) en formant une collerette périphérique (6a) enveloppant ladite couche tampon (5) sur une partie de la hauteur de ladite couche tampon (5).

## Patentansprüche

1. Thermoelektrisches Element (1), insbesondere für thermoelektrischen Wandler (7) mit einem Bauteil aus Schichten, bestehend aus einer zentralen Schicht (3a, 3b) aus thermoelektrischem Material vom Typ N oder P, dann in einer Verbindungsrichtung und beiderseits dieser zentralen Schicht (3a, 3b) einer Zwischenschicht (4), die eine Diffusionssperre bildet, gefolgt von einer Pufferschicht (5) aus einem Metall-Verbundmaterial, diese Pufferschichten (5) sind zur Befestigung an Metallelektroden (2a, 2b) bestimmt, wobei die Gesamtdicke der beiden Pufferschichten (5) größer oder gleich 50% der Dicke der zentralen Schicht (3a, 3b) ist und noch besser größer oder gleich 100% der Dicke der zentralen Schicht (3a, 3b) und am besten größer oder gleich 200% der Dicke der zentralen Schicht (3a, 3b), **dadurch gekennzeichnet, dass** das Material der Pufferschichten (5) aus zwei Metallen besteht, ausgewählt aus der Familie: TiₓAg₁₋ₓ, VₓFe₁₋ₓ, VₓAg₁₋ₓ, TiₓFe₁₋ₓ, mit 0 < x < 1.

2. Thermoelektrisches Element (1) gemäß Anspruch 1, **dadurch gekennzeichnet, dass** die zentrale Schicht (3a, 3b) eine Dicke zwischen 200 µm und 2000 µm aufweist.

3. Thermoelektrisches Element (1) gemäß Anspruch 1 oder 2, **dadurch gekennzeichnet, dass** die Dicke jeder Pufferschicht (5) zwischen 500 µm und 5000 µm liegt.

4. Thermoelektrisches Element (1) gemäß einem der Ansprüche 1 bis 3, **dadurch gekennzeichnet, dass** die Dicke jeder Zwischenschicht (4) zwischen 10 µm und 200 µm liegt.

5. Thermoelektrisches Element (1) gemäß einem der Ansprüche 1 bis 4, **dadurch gekennzeichnet, dass** es im Querschnitt zur Verbindungsrichtung, eine Fläche zwischen 4 mm² und 100 mm² aufweist.

6. Thermoelektrisches Element (1) gemäß einem der Ansprüche 1 bis 5, **dadurch gekennzeichnet, dass** das Material, aus dem die zentrale Schicht (3a, 3b) besteht, Skutterudit vom Typ N oder P ist.

7. Thermoelektrisches Element (1) gemäß einem der Ansprüche 1 bis 6, **dadurch gekennzeichnet, dass** das Material, aus dem die Zwischenschichten (4) bestehen, ausgewählt wird aus der Materialfamilie, zu der Nickel, Titan, Chrom, Tantal, Hafnium, Niobium, Zirconium, Vanadium, Yttrium, Wolfram, Tantalnitrid, Indiumoxid, Kupfersilicid, Wolframnitrid und Titannitrid gehören.

8. Thermoelektrischer Wandler (7), der zwei Platten aus keramischem Material (8, 9) umfasst, im Wesentlichen parallel zueinander, wobei der Abstand zwischen ihnen über eine Baugruppe aus thermoelektrischen Elementen (1) gemäß einem der Ansprüche 1 bis 7 ausgeführt wird und mit Metallelektroden (2a, 2b), die einerseits an den gegenüberliegenden Seiten dieser Platten (8, 9) befestigt sind, entlang einer festgelegten Verteilung und andererseits über eine Lötschicht (6) an den Pufferschichten (5).

9. Thermoelektrischer Wandler (7) gemäß Anspruch 8, **dadurch gekennzeichnet, dass** die Lötschicht (6), die zwischen den Pufferschichten (5) und den Metallelektroden (2a, 2b) angeordnet ist, insbesondere Aluminium enthält.

10. Thermoelektrischer Wandler (7) gemäß Anspruch 8 oder 9, **dadurch gekennzeichnet, dass** die Dicke der Lötschicht (6) gleich oder kleiner der Dicke der Pufferschichten (5) aus Metall-Verbundmaterial ist.

11. Thermoelektrischer Wandler (7) gemäß einem der Ansprüche 8 bis 10, **dadurch gekennzeichnet, dass** die Dicke der Lötschicht (6) zwischen 50% und 200% der Dicke der auf die Platten aus keramischem Material (8, 9) gedruckten Elektroden (2a, 2b) beträgt.

12. Thermoelektrischer Wandler (7) gemäß einem der Ansprüche 8 bis 11, **dadurch gekennzeichnet, dass** die Lötschicht (6) mindestens einen Teil der freien Seite der Metallelektroden (2a, 2b) bedeckt.

13. Thermoelektrischer Wandler (7) gemäß einem der Ansprüche 8 bis 12, **dadurch gekennzeichnet, dass** die Lötschicht (6) um die Pufferschicht (5) liegt und dabei einen umlaufenden Flansch (6a) bildet, der diese Pufferschicht (5) auf einem Teil der Höhe dieser Pufferschicht (5) umgibt.

## Claims

1. Thermoelectric element (1) particularly for thermoelectric converter (7) including an assembly of constituent layers comprising a central layer (3a, 3b) of p- or n-type thermoelectric material, then, in an assembly direction, and on each side of said central layer (3a, 3b), an intermediate layer (4) forming a diffusion barrier followed by a buffer layer (5) made of composite metal material, said buffer layers (5) being intended to be secured to metal electrodes (2a, 2b), the cumulative thickness of the two buffer layers (5) being greater than or equal to 50% of the thickness of the central layer (3a, 3b), and preferably greater than or equal to 100% of the thickness of the central layer (3a, 3b) and very preferably greater than or equal to 200% of the thickness of the central layer (3a, 3b), **characterized in that** the constituent material of the buffer layers (5) is an alloy of two metals chosen from the family: TiₓAg₁₋ₓ, VₓFe₁₋ₓ, VₓAg₁₋ₓ, TiₓFe₁₋ₓ, where 0 < x < 1.

2. Thermoelectric element (1) according to claim 1, **characterized in that** the central layer (3a, 3b) has a thickness of between 200 µm and 2000 µm.

3. Thermoelectric element (1) according to claim 1 or 2, **characterized in that** the thickness of each buffer layer (5) is between 500 µm and 5000 µm.

4. Thermoelectric element (1) according to any one of claims 1 to 3, **characterized in that** each intermediate layer (4) has a thickness between 10 µm and 200 µm.

5. Thermoelectric element (1) according to any one of claims 1 to 4, **characterized in that** it has, along a section transverse to the assembly direction, a surface area between 4 mm² and 100 mm².

6. Thermoelectric element (1) according to any one of claims 1 to 5, **characterized in that** the constituent material of the central layer (3a, 3b) is n- or p-type skutterudite.

7. Thermoelectric element (1) according to any one of claims 1 to 6, **characterized in that** the constituent material of the intermediate layers (4) is chosen from the family of materials comprising nickel, titanium, chromium, tantalum, hafnium, niobium, zirconium, vanadium, yttrium, tungsten, tantalum nitride, indium oxide, copper silicide, tungsten nitride, titanium nitride.

8. Thermoelectric converter (7) comprising two plates of ceramic material (8, 9) substantially parallel to each other and spaced apart from each other by an assembly of thermoelectric elements (1) according to any one of claims 1 to 7 and metal electrodes (2a, 2b) secured on the one hand to facing surfaces of said plates (8, 9) according to a specific distribution, and on the other hand to the buffer layers (5) via a layer of brazing material (6).

9. Thermoelectric converter (7) according to claim 8, **characterized in that** the layer of brazing material (6) disposed between the buffer layers (5) and the metal electrodes (2a, 2b) contains aluminum in particular.

10. Thermoelectric converter (7) according to claim 8 or 9, **characterized in that** the thickness of the layer of brazing material (6) is equal to or less than the thickness of the buffer layers (5) of composite metal material.

11. Thermoelectric converter (7) according to any one of claims 8 to 10, **characterized in that** the thickness of the layer of brazing material (6) is between 50% and 200% of the thickness of the electrodes (2a, 2b) printed on the plates (8, 9) of ceramic material.

12. Thermoelectric converter (7) according to any one of claims 8 to 11, **characterized in that** the layer of brazing material (6) covers at least a portion of the free surface of the metal electrode (2a, 2b).

13. Thermoelectric converter (7) according to any one of claims 8 to 12, **characterized in that** the layer of brazing material (6) extends around the buffer layer (5), forming a peripheral collar (6a) surrounding said buffer layer (5) over a portion of the height of said buffer layer (5).
